# NEW EUROPEAN PATENT SPECIFICATION

(11) **EP 2 068 163 B2**
(45) Date of publication and mention of the opposition decision: **16.02.2022**
(45) Mention of the grant of the patent: 04.01.2012
(21) Application number: 08021165.9
(22) Date of filing: 05.12.2008
(51) Int. Cl.: G01R 33/06, G01R 33/07, G01R 33/00

(54) **Hall sensor array**
Hall-Sensor-Array
Réseau de capteur à effet Hall

(30) Priority: 07.12.2007 GB 0723973
(43) Date of publication of application: 10.06.2009
(73) Proprietor: Melexis Technologies NV, 3980 Tessenderlo (BE)
(72) Inventor: Peev, Rumen, 1138 Sofia (BG); Tsankov, Radostin, 1138 Sofia (BG); Gaydov, Stoyan, 1138 Sofia (BG)
(74) Representative: Falk, Urs

(56) References cited:
- WO-A1-93/15413
- WO-A1-2005/017546
- WO-A1-2005/073744
- US-A1- 2007 046 287

## Description

The present invention relates to a Hall sensor array and in particular to a Hall sensor array configured so as to minimise thermally generated offset errors.

A typical Hall element comprises a plate having two pairs of opposing contacts, the pairs of opposing contacts being arranged such that their respective axes are substantially perpendicular. The pairs of opposing contacts can be used in turn as bias contacts and readout contacts. By processing the outputs, it is possible to compensate some inherent offsets in the Hall signal.

In many implementations, to reduce the offset, a Hall sensor array comprises a pair of such Hall elements mounted side by side. Each element is operable as above but with the restriction that the pairs of opposing contacts used for biasing on each Hall element at any one time have perpendicular axes. The temperature gradient due to the mutual heating of both Hall elements caused by the side by side arrangement generates a Seebeck effect induced offset. In order to compensate this offset it is necessary to measure and process the Hall output in a four-phase cycle using each pair of opposing contacts for biasing and for readout in two directions. This therefore increases the complexity of the biasing and output processing and limits the time sensitivity of the pair of Hall elements.

In the book of R.S. Popovic, "Hall Effect Devices", second edition, Taylor & Francis (2003), ISBN: 978-0-7503-0855-7, chapter 5.6.3: "Reducing offset and 1/f noise", several basic concepts for reducing the offset voltage in Hall devices are shown. One of the basic concepts is the exploitation of matching properties of devices. The offset can be substantially reduced by the mutual compensation of asymmetries in closely spaced Hall plates. If two or four identical integrated Hall plates, biased orthogonally, are properly connected, there asymmetries tend to cancel out, leaving the output signal virtually free of offset. This technique is called *offset reduction by pairing.* Another technique is a dynamic offset cancellation technique known as *connection-commutation, switched Hall plate, or spinning-current technique.* In a Hall device with a shape which is invariant under a rotation of π/2, diagonally situated contacts of the Hall device are periodically commutated and alternately used as current and sense contacts. The commutation is performed using a group of switches.

WO 01/18556 A1 discloses a Hall sensor array for measuring a magnetic field with offset compensation comprising a first pair and at least one additional pair of Hall sensor elements. Each Hall sensor element has four connections, of which a first and a third connection act as power supply connections for supplying an operating current and a second and fourth connection act as measurement connections for measuring a Hall voltage. The Hall sensor elements are arranged in such a way that the current directions of the operating current in the two Hall sensor elements of each pair are offset at an angle of approximately 90° in relation to one another. The Hall sensor elements of the additional pair(s) are arranged in such a way that their current directions are offset at an angle of approximately 90°/n, in relation to the current directions of the first pair, whereby n is the total number of Hall sensor element pairs and n ≥ 2.

EP 548391 A1 discloses a Hall sensor equipped with a device for the orthogonal switching of the Hall detector supply current and the Hall voltage taps for the purpose of improved offset compensation. A summing device determines an offset-compensated Hall voltage value from a first and a second precompensated Hall voltage value. These Hall voltage values are formed by means of a Hall detector which contains at least one first and one second Hall element for precompensating the offset voltage. The first and second Hall element are geometrically identical to one another and orthogonally switchable. The geometric alignment of the first and second Hall element encloses an angle different from 0° and 180°.

WO9315413 discloses a Hall sensor array with four Hall elements, the individual elements arranged in a square configuration with a Hall element provided at each corner of said square. A two-phase measurement cycle is used, to switch the biasing current between the two pairs of opposing contacts of each Hall element in the array. The four adjacent contacts nearest the centre of the device are interwired and always supplied with the same potential, If the array is seen as two pairs of Hall elements, arranged along the diagonals of the square, the Hall elements have, at any given time, biasing currents that are offset by 180 degrees.

WO2005017546 discloses a Hall sensor array with four Hall elements arranged in a square configuration. A two-phase measurement cycle is used. The contacts nearest the centre of the array are interwired along the diagonals of the array. If seen as two pairs of Hall elements, arranged along the diagonals of the square, the pairs of Hall elements disclosed in WO2005017546 have biasing currents that are offset by 180 degrees.

WO2005073744 discloses a Hall sensor array with at least four Hall plates, each Hall plate consisting of eight contacts. As in the case of WO9315413, these may be seen as two pairs of Hall elements arranged diagonally. WO2005073744 only discloses diagonally oriented Hall elements with a 180 degree offset in biasing currents.

US20070046287 discloses an array of identical four contact Hall elements arranged into a number of columns and rows. During measurements current is applied to one of the Hall elements. Any other elements in the same row or column as the active one are set to an off-state to prevent shunt currents running therethrough. The direction of the biasing current may be switched 90 degrees. To eliminate offset, the biasing current is switched back and forth several times during a measurement cycle, until the offset has been sufficiently reduced. Alternatively, a four-phase measurement cycle maybe used.

It is therefore an object of the present invention to provide an improved Hall element arrangement that overcomes or alleviates the above problem.

According to a first aspect of the present invention there is provided a Hall sensor array comprising a single pair of Hall elements for use in a two-phase measurement cycle as recited in claim 1.

This provides an arrangement wherein the inherent offset of both Hall elements including the offset caused by mutual heating due to the Seebeck effect can be fully compensated in a two-phase cycle. Furthermore the unoccupied corners of the array area can incorporate other components of an integrated circuit containing the Hall sensor array.

Preferably, the pairs of opposing contacts used for biasing on each Hall element at any one time have perpendicular axes and the adjacent corners of the Hall elements are biased by the same polarity during the different phases. Preferably each Hall element takes up substantially a whole quadrant of the array area.

In alternative embodiments, the array may comprise additional pairs of Hall elements. The additional pairs are preferably each laid out in the above manner. Preferably, such additional pairs are positioned such that adjacent Hall elements from adjacent pairs are also diagonally opposed.

According to a second aspect of the present invention there is provided a method of biasing the output of a Hall sensor array according to the first aspect of the invention characterised in that the final output is calculated over a two-phase cycle.

This provides a method wherein a four-phase cycle using each pair of opposing contacts for biasing and for readout in two directions is unnecessary and therefore decreases the complexity of the biasing and output processing and improves the time sensitivity of the pair of Hall elements.

The method of the second aspect of the present invention may incorporate any or all features of the first aspect of the present invention as desired or as appropriate.

In order that the present invention is more clearly understood, one embodiment is described further below, by way of example only, and with reference to the accompanying drawings, in which:
- Figure 1: is a schematic illustration of a prior art Hall sensor array incorporating a pair of Hall elements in side by side arrangement;
- Figure 2: is a schematic illustration of a Hall sensor array according to the present invention incorporating a pair of Hall elements in diagonal arrangement; and
- Figure 3: is a schematic illustration of a Hall sensor array according to the present invention incorporating two pairs of Hall elements in diagonal arrangement.

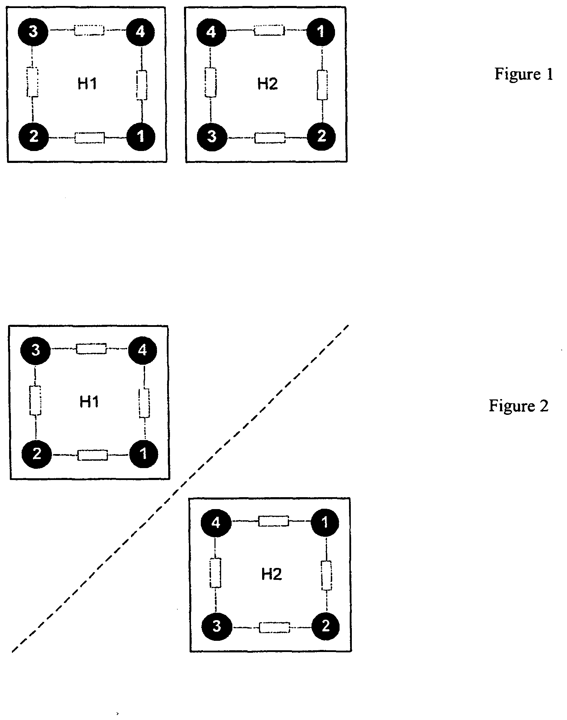

Turning first to the prior art sensor of figure 1, this comprises a pair of hall elements H1 and H2 provided side by side. Each Hall element has two pairs of opposed contacts 2,4 and 1,3 which can be used for either biasing or readout. As each Hall element H1, H2 generates heat during operation, a temperature gradient is set up across the Hall plates, the temperature being highest along the adjacent edges of H1 and H2. This being the case, a offset generated by the Seebeck effect is present in the readout Hall voltages. This offset cannot be fully compensated in a two-phase cycle. To compensate for this offset a four-phase biasing and sensing cycle is used as set out in table 1.

**Table 1**

| | Phase 1 | Phase 2 | Phase 3 | Phase 4 |
|---|---|---|---|---|
| VDD | 1 | 4 | 3 | 2 |
| OUT+ | 2 | 1 | 4 | 3 |
| GND | 3 | 2 | 1 | 4 |
| OUT- | 4 | 3 | 2 | 1 |

As a final output can only be calculated after a full cycle, this limits the time sensitivity of a sensor of this form and increases the complexity of the biasing and output processing.

Turning now to figure 2, a Hall sensor array according to the present invention is shown. In this sensor, the Hall elements H1 and H2 are arranged at diagonally opposed quadrants of a two by two array. In this array, as is usual, the pairs of opposing contacts used for biasing on each Hall element at any one time have perpendicular axes. Additionally in this array, the adjacent corners of both Hall elements are biased by the same polarity during the different phases as is set out in table 2.

**Table 2**

| | Phase 1 | Phase 2 |
|---|---|---|
| VDD | 1 | 4 |
| OUT+ | 2 | 1 |
| GND | 3 | 2 |
| OUT- | 4 | 3 |

Refering to table 2 and figure 2, during Phase 1 the two outputs for Hall element H1, OUT- and OUT+, are symmetrically positioned with regard to Hall element H2 and thus their contribution to the Seebeck effect induced offset is zero. For Hall element H2 output OUT- is in the closest position and output OUT+ is in the farthest position towards Hall element H1 and thus the resulting offset due to the Seebeck effect is non-zero. In contrast, in Phase 2 for Hall element H2 both outputs OUT- and OUT+ are symmetrically positioned with regard to the Hall element H1 and thus their contribution to the Seebeck effect induced offset is zero. For Hall element H I output OUT+ is in the closest position and output OUT- is in the farthest position towards the Hall element H2 and thus the resulting offset is non-zero.

Because both Hall elements have equal shape and size the resulting offset due to mutual heating including Seebeck effect induced offset has equal amplitude in both phases. However, as the offsets generated by H1 and H2 have an opposite sign full compensation is possible when the final output is calculated over a two phase cycle using appropriate Hall signal processing.

Additionally, this means that other components can be placed in the empty quadrants, assuming that they are substantially symmetrically disposed about the axis of symmetry S, with respect to thermal properties. This allows the invention to be implemented with an efficient use of circuit area. Such other components may include Hall sensor biasing means, processing means, other sensing means, input and/or output means or any other suitable components.

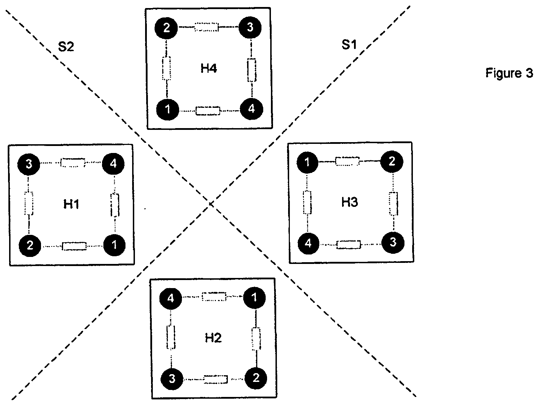

In an alternative embodiment of the present invention, two or more pairs of Hall elements may be arranged such that each Hall element is diagonally opposed to all Hall elements adjacent to it, in a chess board like formation. This is illustrated in figure 3 wherein H1 and H2 form a first pair of elements and H3 and H4 form a second pair of elements, the pairs being arranged such that all the elements are diagonally opposed to their neighbours. In such an arrangement a two phase cycle can be used, the two phase cycle being the same as that used in the embodiment of figure 2.

It is of course to be understood that the present invention is not to be restricted to the details of the above embodiment which is described by way of example only.

## Claims

1. A Hall sensor array comprising a single pair of Hall elements for use in a two-phase measurement cycle, each of the Hall elements comprising a square plate having two pairs of opposing contacts in the corners of the square plate, the pairs of opposing contacts being arranged such that their respective axes are substantially perpendicular, wherein said square plates of said pair are arranged in diagonally opposite quadrants of a square which describes said Hall sensor array and at opposite corners of said square, **characterised in that** each Hall element takes up substantially a whole quadrant of the array area, that the other two diagonally opposite quadrants of the square do not contain a Hall element and that the array is configured such that the respective axes of the pair of opposing contacts used at any given time to bias each of the Hall elements of the pair are perpendicular.

2. A Hall sensor array according to claim 1 wherein the adjacent corners of the Hall elements are biased by the same polarity during consecutive measurement phases.

3. A method of biasing the output of a Hall sensor array comprising a single pair of Hall elements, each of the Hall elements comprising a square plate having two pairs of opposing contacts in the corners of the square plate, the pairs of opposing contacts being arranged such that their respective axes are substantially perpendicular, wherein said square plates of said pair are arranged in diagonally opposite quadrants of a square which describes said Hall sensor array and at opposite corners of said square, **characterised in that** each Hall element takes up substantially a whole quadrant of the array area, that the other two diagonally opposite quadrants of the square do not contain a Hall element, and **in that** the final output is calculated over a two-phase cycle, wherein one pair of said opposing contacts from each of said Hall elements is biased during each of said phases in said cycle, and wherein the respective axes of the pair of opposing contacts used at any given time to bias the two Hall elements of a pair are perpendicular.

## Patentansprüche

1. Ein Hall-Sensorarray mit einem einzigen Paar von Hall-Elementen zur Verwendung in einem zweiphasigen Messzyklus, wobei jedes der Hall-Elemente eine quadratische Platte mit zwei Paaren gegenüberliegender Kontakte in den Ecken der quadratischen Platte aufweist, wobei die Paare gegenüberliegender Kontakte derart angeordnet sind, dass ihre jeweiligen Achsen im Wesentlichen senkrecht angeordnet sind, wobei die quadratischen Platten des Paars in diagonal gegenüberliegenden Quadranten eines Quadrats, das den Hall-Sensor-Array beschreibt, und an gegenüberliegenden Ecken des Quadrats angeordnet sind, **dadurch gekennzeichnet, dass** jedes Hall-Element im Wesentlichen einen vollständigen Quadranten der Array-Fläche einnimmt, dass die anderen beiden diagonal gegenüberliegenden Quadranten des Quadrats kein Hall-Element enthalten und dass der Array derart konfiguriert ist, dass die jeweiligen Achsen des Paars gegenüberliegender Kontakte, die zu irgendeiner bestimmten Zeit verwendet werden, um jedes der Hall-Elemente des Paars vorzuspannen, senkrecht liegen.

2. Ein Hall-Sensorarray nach Anspruch 1, wobei die benachbarten Ecken der Hall-Elemente während aufeinanderfolgender Messphasen durch die gleiche Polarität vorgespannt werden.

3. Ein Verfahren zum Vorspannen des Outputs eines Hall-Sensorarrays, der ein einziges Paar von Hall-Elementen aufweist, wobei jedes der Hall-Elemente eine quadratische Platte mit zwei Paaren von gegenüberliegenden Kontakten in den Ecken der quadratischen Platte aufweist, wobei die Paare gegenüberliegender Kontakte derart angeordnet sind, dass ihre jeweiligen Achsen im Wesentlichen senkrecht angeordnet sind, wobei die quadratischen Platten des Paars in diagonal gegenüberliegenden Quadranten eines Quadrats, welches den Hall-Sensorarray beschreibt, und an gegenüberliegenden Ecken des Quadrats angeordnet sind, **dadurch gekennzeichnet, dass** jedes Hall-Element im Wesentlichen einen vollständigen Quadranten der Array-Fläche einnimmt, dass die anderen beiden diagonal gegenüberliegenden Quadranten des Quadrats kein Hall-Element enthalten, und dass der finale Output über einen Zwei-Phasen Zyklus berechnet wird, wobei ein Paar der gegenüberliegenden Kontakte von jedem der Hall Elemente während jeder der Phasen in dem Zyklus vorgespannt wird, und wobei die jeweiligen Achsen der Paare gegenüberliegender Kontakte, die zu einer bestimmten Zeit dazu verwendet werden, um die zwei Hall-Elemente eines Paars vorzuspannen, senkrecht liegen.

## Revendications

1. Réseau de capteurs à effet Hall comprenant une seule paire d'éléments Hall à utiliser dans un cycle de mesure à deux phases, chacun des éléments Hall comprenant une plaque carrée ayant deux paires de contacts opposés aux coins de la plaque carrée, les paires des contacts opposés étant agencées de sorte que leurs axes respectifs soient essentiellement perpendiculaires, où lesdites plaques carrées de ladite paire sont agencées dans des quadrants diagonalement opposés d'un carré qui décrit ledit réseau de capteurs à effet Hall, et aux coins opposés dudit carré, **caractérisé en ce que** chaque élément Hall occupe essentiellement un quadrant entier de la surface du réseau, **en ce que** les deux autres quadrants diagonalement opposés du carré ne contiennent pas d'élément Hall et **en ce que** le réseau est configuré de sorte que les axes respectifs de la paire de contacts opposés utilisés à n'importe quel moment donné pour polariser chacun des éléments Hall de la paire soient perpendiculaires.

2. Réseau de capteurs à effet Hall selon la revendication 1, dans lequel les coins adjacents des éléments Hall sont polarisés par la même polarité durant des phases de mesure consécutives.

3. Procédé de polarisation de la sortie d'un réseau de capteurs à effet Hall comprenant une seule paire d'éléments Hall, chacun des éléments Hall comprenant une plaque carrée ayant deux paires de contacts opposés aux coins de la plaque carrée, les paires de contacts opposés étant agencées de sorte que leurs axes respectifs soient essentiellement perpendiculaires, où lesdites plaques carrées de ladite paire sont agencées dans des quadrants diagonalement opposés d'un carré qui décrit ledit réseau de capteurs à effet Hall et aux coins opposés dudit carré, **caractérisé en ce que** chaque élément Hall occupe essentiellement un quadrant entier de la surface du réseau, **en ce que** les deux autres quadrants diagonalement opposés du carré ne contiennent pas d'élément Hall et **en ce que** la sortie finale est calculée sur un cycle à deux phases, où une paire desdits contacts opposés de chacun desdits éléments Hall est polarisée durant chacune desdits phases dans ledit cycle, et où les axes respectifs de la paire de contacts opposés utilisés à n'importe quel moment donné pour polariser les deux éléments Hall d'une paire soient perpendiculaires.
